# EUROPÄISCHE PATENTSCHRIFT

(11) **EP 1 749 317 B1**
(45) Veröffentlichungstag und Bekanntmachung des Hinweises auf die Patenterteilung: **18.01.2017**
(21) Anmeldenummer: 05747600.4
(22) Anmeldetag: 25.04.2005
(51) Int. Cl.: H01L 21/20, H01L 21/24, H01L 21/76, H01L 21/363, H01L 33/00

(54) **VERFAHREN ZUR HERSTELLUNG EINES BEREICHS MIT REDUZIERTER ELEKTRISCHER LEITFÄHIGKEIT INNERHALB EINER HALBLEITERSCHICHT UND OPTOELEKTRONISCHES HALBLEITERBAUELEMENT**
METHOD FOR PRODUCING AN AREA HAVING REDUCED ELECTRICAL CONDUCTIVITY WITHIN A SEMICONDUCTOR LAYER AND OPTOELECTRONIC SEMICONDUCTOR ELEMENT
PROCÉDÉ DE RÉALISATION D'UNE RÉGION PRÉSENTANT UNE CONDUCTIVITÉ ÉLECTRIQUE RÉDUITE À L'INTÉRIEUR D'UNE COUCHE DE SEMI-CONDUCTEUR ET COMPOSANT SEMI-CONDUCTEUR OPTO-ÉLECTRONIQUE

(30) Priorität: 28.05.2004 DE 102004026231
(43) Veröffentlichungstag der Anmeldung: 07.02.2007
(73) Patentinhaber: OSRAM Opto Semiconductors GmbH, 93055 Regensburg (DE)
(72) Erfinder: ILLEK, Stefan, 93093 Donaustauf (DE); STEIN, Wilhelm, 01324 Dresden (DE); WALTER, Robert, 92331 Parsberg (DE); WIRTH, Ralph, 93138 Lappersdorf (DE)
(74) Vertreter: Epping - Hermann - Fischer
(86) Internationale Anmeldenummer: PCT/DE2005/000753
(87) Internationale Veröffentlichungsnummer: WO 2005/117147

(56) Entgegenhaltungen:
- EP-A- 1 523 047
- KOVACIK A ET AL: "APPLICATION OF ZNO FILMS FOR ZNO/GAINP HETEROJUNCTION BIPOLAR PHOTOTRANSISTORS PREPARATION" ELEKTROTECHNICKY CASOPIS - JOURNAL OF ELECTRICAL ENGINEERING, ELEKTROTECHNICKA KAKULTA STU, BRATISLAVA,, SL, Bd. 46, Nr. 11, 1995, Seiten 370-374, XP009034477 ISSN: 0013-578X
- LAWRENCE D J ET AL: "ZINC DIFFUSION PROCESS FOR GAAS0.6PA0.4 RED LIGHT EMITTING DIODE FABRICATION IN AN UNDERGRADUATE LABORATORY" PROCEEDINGS OF THE 12TH BIENNIAL UNIVERSITY/GOVERNMENT/INDUSTRY MICROELECTRONICS SYMPOSIUM. UGIM '97. ROCHESTER, NY, JULY 20 - 23, 1997, BIENNIAL UNIVERSITY/GOVERNMENT/INDUSTRY MICROELECTRONICS SYMPOSIUM, NEW YORK, NY : IEEE, US, 20. Juli 1997 (1997-07-20), Seiten 169-172, XP000792032 ISBN: 0-7803-3791-3
- NAKAHARA K ET AL: "IMPROVED EXTERNAL EFFICIENCY INGAN-BASED LIGHT-EMITTING DIODES WITH TRANSPARENT CONDUCTIVE GA-DOPED ZNO AS P-ELECTRODES" JAPANESE JOURNAL OF APPLIED PHYSICS, PUBLICATION OFFICE JAPANESE JOURNAL OF APPLIED PHYSICS. TOKYO, JP, Bd. 43, Nr. 2A, 1. Februar 2004 (2004-02-01), Seiten L180-L182, XP001191835 ISSN: 0021-4922
- NISHIZONO K ET AL: "METAL/AL-DOPED ZNO OHMIC CONTACT FOR ALGAN/GAN HIGH ELECTRON MOBILITY TRANSISTOR" APPLIED PHYSICS LETTERS, AMERICAN INSTITUTE OF PHYSICS. NEW YORK, US, Bd. 84, Nr. 20, 17. Mai 2004 (2004-05-17), Seiten 3996-3998, XP001211498 ISSN: 0003-6951
- AKIHIRO SHIMA: "670NM WINDOW LASER DIODE PERFORMS 150MW SINGLE TRANSVERSE-MODE OPERATION" JEE JOURNAL OF ELECTRONIC ENGINEERING, DEMPA PUBLICATIONS INC. TOKYO, JP, Bd. 30, Nr. 313, Januar 1993 (1993-01), Seiten 100-103, XP000330943 ISSN: 0385-4507

## Beschreibung

Verfahren zur Herstellung eines Bereichs mit reduzierter elektrischer Leitfähigkeit innerhalb einer Halbleiterschicht und optoelektronisches Halbleiterbauelement

Diese Patentanmeldung beansprucht die Priorität der deutschen Patentanmeldung 102004026231.4 -33.

Die Erfindung betrifft ein Verfahren zur Herstellung einer elektrisch leitfähigen III-V-Halbleiterschicht und ein optoelektronisches Halbleiterbauelement.

Die Druckschift A. Kováčik et al., "Application of ZnO films for ZnO/GaInP heterojunction bipolar phototransistors preparation", J. Electr. Eng. 46 (1995), 370-374, beschreibt ein Verfahren, bei dem Zink aus einer ZnO-Schicht als p-Dotierstoff durch Tempern in eine III-V-Halbleiterschicht eindiffundiert wird.

In der Druckschrift EP 0 723 285 A2 wird beschrieben, eine Diffusionsquelle auf ein III-V-Halbleitersubstrat aufzubringen, bei der es sich um eine ZnO-Schicht handeln kann. Durch einen Temperprozess wird Zink aus der Diffusionsquelle in das Halbleitersubstrat diffundiert, um eine p-Typ Diffusionsregion auszubilden, die mit dem umgebenden n-Typ Halbleitersubstrat 10 einen pn-Übergang ausbildet.

Bei optoelektronischen Halbleiterbauelementen, insbesondere Lumineszenzdioden oder Halbleiterlaservorrichtungen, besteht oftmals der Wunsch, den Stromfluss durch den Halbleiterkörper gezielt durch einzelne Teilbereiche der Halbleiterschichten zu lenken, um die Effizienz des Bauelements zu erhöhen.

Zum Beispiel soll bei strahlungsemittierenden optoelektronischen Bauelementen kein Strom unterhalb eines elektrischen Anschlusskontakts (Bondpad) injiziert werden, da elektromagnetische Strahlung, die in unterhalb des Anschlusskontakts liegenden Bereichen der aktiven Zone erzeugt wird, zu einem verhältnismäßig großen Anteil innerhalb des Anschlusskontakts absorbiert würde, und deshalb nicht aus dem Bauelement ausgekoppelt werden könnte.

Ferner besteht oftmals auch der Wunsch, die von einem Strom durchflossene Fläche des optoelektronischen Halbleiterbauelements auf einen Teilbereich des Halbleiterchips zu beschränken, um in diesem Teilbereich eine erhöhte Ladungsträgerdichte und dadurch eine kürzere Schaltzeit des optoelektronischen Bauelements zu erreichen.

Bekannte Methoden zur Beeinflussung des Strompfades durch ein Halbleiterbauelement sind die Unterlegung eines elektrischen Anschlusskontaktes mit einer isolierenden Schicht, die Implantation von Protonen in Teilbereiche einer Halbleiterschicht oder die selektive Oxidation von epitaktisch hergestellten AlAs-Schichten, um auf diese Weise Strombegrenzungsblenden herzustellen.

Bei Halbleitermaterialien mit einer hohen Querleitfähigkeit ist die Wirksamkeit der Unterlegung des Anschlusskontaktes mit einer isolierenden Schicht allerdings auf oberflächennahe Bereiche beschränkt, da die Leitfähigkeit des Halbleitermaterials selbst dadurch nicht beeinflusst wird. Mit den zuvor genannten Methoden der Protonenimplantation oder der selektiven Oxidation von AlAs-Schichten kann dagegen die Leitfähigkeit einzelner Teilbereiche einer Halbleiterschicht verändert werden. Allerdings sind diese Methoden technisch verhältnismäßig aufwendig.

Der Erfindung liegt die Aufgabe zugrunde, ein Verfahren anzugeben, mit dem mit vergleichsweise geringem Aufwand ein Bereich mit reduzierter elektrischer Leitfähigkeit innerhalb einer elektrisch leitfähigen III-V-Halbleiterschicht erzeugt werden kann, und ein vorteilhaftes optoelektronisches Bauelement mit einer derartigen III-V-Halbleiterschicht anzugeben.

Diese Aufgabe wird durch ein Verfahren nach Patentanspruch 1 beziehungsweise durch ein optoelektronisches Halbleiterbauelement nach Patentanspruch 15 gelöst. Vorteilhafte Ausgestaltungen und Weiterbildungen der Erfindung sind Gegenstand der abhängigen Ansprüche.

Bei einem Verfahren zur Herstellung von mindestens einem Bereich mit reduzierter elektrischer Leitfähigkeit innerhalb einer elektrisch leitfähigen III-V-Halbleiterschicht wird gemäß der Erfindung auf den Bereich der Halbleiterschicht eine ZnO-Schicht aufgebracht und anschließend bei einer Temperatur von 300 °C bis 500 °C getempert, wodurch die elektrische Leitfähigkeit des Bereichs mit reduzierter Leitfähigkeit gegenüber dem Bereich oder den Bereichen der III-V-Halbleiterschicht, die an den Bereich mit reduzierter Leitfähigkeit angrenzen, um mindestens einen Faktor 2 reduziert wird. Durch das Verfahren wird also vorteilhaft ein Bereich innerhalb einer III-V-Halbleiterschicht erzeugt, in dem die elektrische Leitfähigkeit gegenüber dem Bereich oder den Bereichen der III-V-Halbleiterschicht, die an den Bereich mit reduzierter Leitfähigkeit angrenzen, reduziert ist. Beispielsweise weist die III-V-Halbleiterschicht eine elektrische Leitfähigkeit σ₁ auf, und es wird ein Bereich mit einer gegenüber σ₁ reduzierten elektrischen Leitfähigkeit σ₂ innerhalb der elektrisch leitfähigen III-V-Halbleiterschicht erzeugt, so dass 2σ₂ < σ₁ gilt.

Die ZnO-Schicht wird bevorzugt bei einer Temperatur von weniger als 150 °C, bevorzugt zwischen einschließlich 25 °C und einschließlich 120 °C, auf das III-V-Halbleitermaterial abgeschieden. Vorteilhaft wird die ZnO-Schicht mittels Sputtern aufgebracht. Das anschließende Tempern erfolgt bei einer Temperatur von etwa 300 °C bis 500 °C.

Zur Definition der Bereiche, in denen die Leitfähigkeit der Halbleiterschicht reduziert werden soll, kann die ZnO-Schicht beispielsweise mittels Photolithographie oder einer Lift-Off-Technik strukturiert werden. Zur Verbesserung der Leitfähigkeit der ZnO-Schicht kann diese mit Al dotiert sein, vorzugsweise mit einer Konzentration von bis zu 3 %.

Die Erfindung beruht auf der Erkenntnis, dass die elektrische Leitfähigkeit, insbesondere auch die Querleitfähigkeit, einer III-V-Halbleiterschicht durch das Aufbringen einer ZnO-Schicht und einen anschließenden Temperprozess gezielt beeinflusst werden kann. Insbesondere hat sich herausgestellt, dass die Reduzierung der Leitfähigkeit der III-V-Halbleiterschicht stark von der Temperatur abhängt, bei der die ZnO-Schicht aufgebracht wird. Bei einer Abscheidtemperatur von weniger als 150 °C ist es beispielsweise möglich, die Leitfähigkeit einer III-V-Halbleiterschicht um mindestens einen Faktor 2, bevorzugt um mindestens einen Faktor 5 und besonders bevorzugt sogar um mindestens einen Faktor 10 zu reduzieren. Andererseits wird die Leitfähigkeit der III-V-Halbleiterschicht durch das Aufbringen einer ZnO-Schicht bei einer Temperatur von mehr als 150 °C, beispielsweise bei etwa 250 °C, und anschließendes Tempern zumindest weniger stark, bevorzugt sogar nur vernachlässigbar gering beeinflusst.

Die ZnO-Schicht kann nach dem Tempern entfernt werden oder auch auf der Halbleiterschicht verbleiben und beispielsweise innerhalb eines optoelektronischen Bauelements als Stromaufweitungsschicht fungieren.

Besonders geeignet ist das erfindungsgemäße Verfahren für eine III-V-Halbleiterschicht, die eines der Halbleitermaterialien In_{1-x-y}GaₓAl_{y}P mit 0≤x+y≤1, 0≤x≤1, 0≤y≤1 oder Al₁₋ₓGaₓAs mit 0≤x≤1 enthält. Die III-V-Halbleiterschicht ist vorzugsweise p-dotiert.

Bei einem bevorzugten Verfahren gemäß der Erfindung ist die III-V-Halbleiterschicht in einem optoelektronischen Bauelement enthalten, insbesondere in einer Lumineszenzdiode oder in einer Halbleiterlaservorrichtung. In einer besonders bevorzugten Ausführungsform enthält das optoelektronische Bauelement eine strahlungsemittierende aktive Zone und mittels des Bereichs mit reduzierter elektrischer Leitfähigkeit wird der Stromfluss durch Teilbereiche der aktiven Zone vermindert. Dazu ist der Bereich mit reduzierter elektrischer Leitfähigkeit vorteilhaft zwischen einem elektrischen Anschlusskontakt des optoelektronischen Bauelements und der aktiven Zone angeordnet.

Eine vorteilhafte Variante des erfindungsgemäßen Verfahrens besteht darin, eine erste ZnO-Schicht auf einen ersten Bereich der Halbleiterschicht abzuscheiden und eine zweite ZnO-Schicht auf einen zweiten Bereich der Halbleiterschicht abzuscheiden, wobei die Abscheidtemperatur der zweiten ZnO-Schicht gegenüber der Abscheidtemperatur der ersten ZnO-Schicht derart erhöht ist, dass bei dem anschließenden Tempern die Leitfähigkeit des zweiten Bereichs der Halbleiterschicht zumindest weniger reduziert wird als die Leitfähigkeit des ersten Bereichs. Bevorzugt wird die zweite ZnO-Schicht bei einer Temperatur von mehr als 150 °C, beispielsweise bei etwa 250 °C, aufgebracht.

Weiterhin ist im Rahmen der Erfindung ein optoelektronisches Halbleiterbauelement vorgesehen, das eine III-V-Halbleiterschicht enthält, die mindestens einen mit einem Verfahren gemäß der Erfindung hergestellten Bereich mit reduzierter elektrischer Leitfähigkeit aufweist.

Eine bevorzugte Ausführungsform eines optoelektronischen Halbleiterbauelements gemäß der Erfindung weist eine III-V-Halbleiterschicht auf, die in mindestens einem ersten Bereich mit einer ZnO-Schicht bedeckt ist, wobei die Leitfähigkeit in dem Halbleiterkörper in dem von der ZnO-Schicht bedeckten ersten Bereich um mindestens einen Faktor 2 geringer ist als in den lateral angrenzenden Bereichen der Halbleiterschicht.

Vorteilhaft ist die elektrische Leitfähigkeit des ersten Bereichs der III-V-Halbleiterschicht um mindestens einen Faktor 5 und besonders bevorzugt um mindestens einen Faktor 10 geringer als in den lateral angrenzenden Bereichen der Halbleiterschicht. Die III-V-Halbleiterschicht enthält vorzugsweise eines der Halbleitermaterialien In_{1-x-y}GaₓAl_{y}P mit 0≤x+y≤1, 0≤x≤1, 0≤y≤1 oder Al₁₋ₓGaₓAs mit 0≤x≤1.

Auf einem zweiten Bereich der Halbleiterschicht kann eine zweite ZnO-Schicht abgeschieden sein, wobei die Leitfähigkeit des zweiten Bereichs der Halbleiterschicht größer ist als die Leitfähigkeit des ersten Bereichs.

Insbesondere können die erste ZnO-Schicht und die zweite ZnO-Schicht aneinander angrenzen und zwischen der III-V-Halbleiterschicht und dem Anschlusskontakt eines optoelektronischen Bauelements angeordnet sein. Die erste ZnO-Schicht und die zweite ZnO-Schicht bilden so auf vorteilhafte Weise gemeinsam eine Stromaufweitungsschicht aus.

Bevorzugt enthält ein optoelektronisches Halbleiterbauelement eine strahlungsemittierende aktive Zone, wobei der Bereich mit reduzierter elektrischer Leitfähigkeit zwischen einem elektrischen Anschlusskontakt des optoelektronischen Bauelements und der aktiven Zone angeordnet ist, um die Strominjektion in einem dem Anschlusskontakt gegenüberliegenden Bereich der aktiven Zone zu vermindern. Dadurch wird die Erzeugung von Strahlung in diesem Bereich vermindert und damit die Absorption im Abschlusskontakt vorteilhaft vermindert.

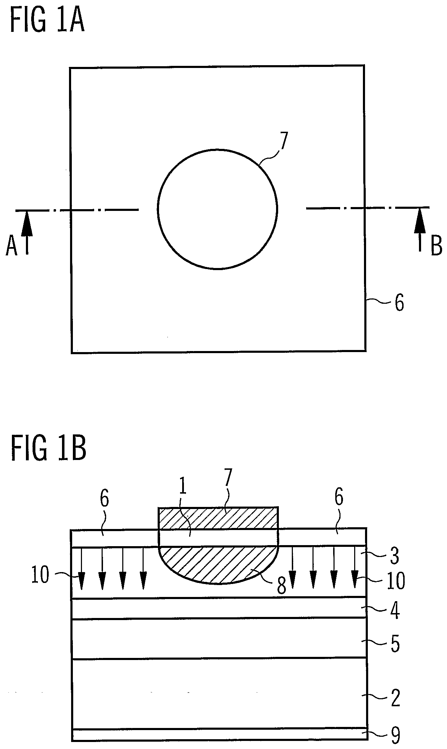

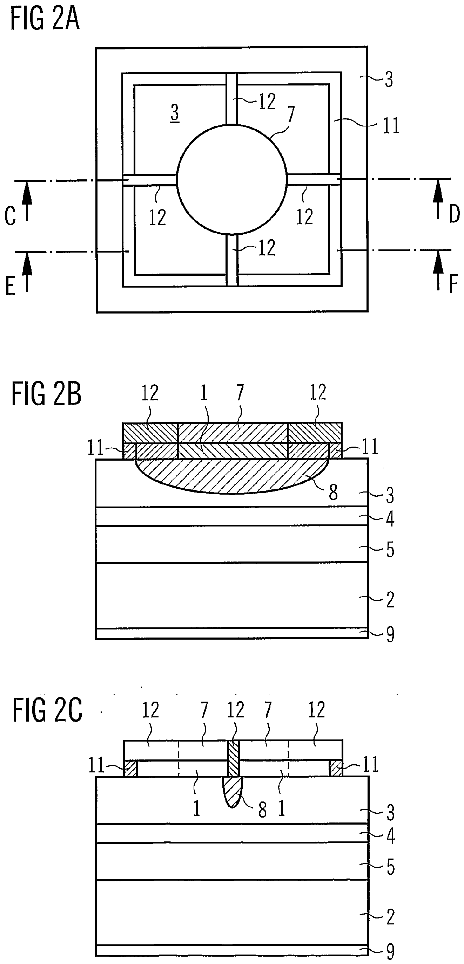

Die Erfindung wird im folgenden anhand von zwei Ausführungsbeispielen in Zusammenhang mit den Figuren 1 und 2 näher erläutert.

Es zeigen:
- Figur 1a: eine schematisch dargestellte Aufsicht auf ein optoelektronisches Bauelement gemäß einem ersten Ausführungsbeispiel der Erfindung,
- Figur 1b: eine schematische Darstellung eines Querschnitts entlang der Linie AB des in Figur 1a dargestellten Ausführungsbeispiels der Erfindung,
- Figur 2a: eine schematisch dargestellte Aufsicht auf ein optoelektronisches Bauelement gemäß einem zweiten Ausführungsbeispiel der Erfindung,
- Figur 2b: eine schematische Darstellung eines Querschnitts entlang der Linie CD des in Figur 2a dargestellten Ausführungsbeispiels der Erfindung und
- Figur 2c: eine schematische Darstellung eines Querschnitts entlang der Linie EF des in Figur 2a dargestellten Ausführungsbeispiels der Erfindung.

Gleiche oder gleichwirkende Elemente sind in den Figuren mit den gleichen Bezugszeichen versehen.

Das in den Figuren 1a und 1b dargestellte erste Ausführungsbeispiel eines erfindungsgemäßen optoelektronischen Bauelements enthält auf einem Substrat 2 mindestens eine p-dotierte III-V-Halbleiterschicht 3 und mindestens eine n-dotierte Halbleiterschicht 5, zwischen denen eine strahlungsemittierende aktive Zone 4 ausgebildet ist. Die in der Figur 1b nur schematisch dargestellte Halbleiterschichtenfolge 3, 4, 5 kann im Rahmen der Erfindung eine beliebige für Lumineszenzdioden oder Halbleiterlaservorrichtungen übliche Ausführungsform aufweisen. Insbesondere können auch Quantenschichten als strahlungsemittierende aktive Zone 4 vorgesehen sein.

Auf einen Teilbereich 8 der III-V-Halbleiterschicht 3 ist eine erste ZnO-Schicht 1 aufgebracht, die mittels Sputtern bei einer Temperatur zwischen 25 °C und 120 °C abgeschieden ist. Durch einen nach der Abscheidung der ersten ZnO-Schicht 1 erfolgten Temperprozess bei einer Temperatur zwischen 300 °C und 500 °C wurde innerhalb der III-V-Halbleiterschicht 3 ein Bereich 8 mit reduzierter elektrischer Leitfähigkeit erzeugt.

In lateraler Richtung grenzt an die erste ZnO-Schicht 1 eine zweite ZnO-Schicht 6 an, die im Gegensatz zur ersten ZnO-Schicht bei einer höheren Abscheidtemperatur von mehr als 150 °C, beispielsweise etwa 250 °C, aufgebracht wurde.

Das Aufbringen der ersten ZnO-Schicht 1 und der zweiten ZnO-Schicht 6 kann zum Beispiel derart erfolgen, dass zuerst die zweite ZnO-Schicht 6 ganzflächig auf die III-V-Halbleiterschicht 3 aufgebracht wird und anschließend mit einer Maskenschicht, die eine Öffnung in dem für die erste ZnO-Schicht vorgesehenen Teilbereich enthält, bedeckt wird. Die zweite ZnO-Schicht 6 wird in diesem Teilbereich beispielsweise mit einem Ätzverfahren entfernt und anschließend die erste ZnO-Schicht 1 bei einer Abscheidtemperatur von weniger als 150 °C aufgebracht. Anschließend wird ein erster Anschlusskontakt 7 aufgebracht. Von den mit der Maskenschicht bedeckten Bereichen der zweiten ZnO-Schicht 6 kann das dort abgeschiedene Material der ersten ZnO-Schicht 1 und des Anschlusskontakts 7 zusammen mit der Maskenschicht abgehoben werden (Lift-Off-Technik). Anschließend erfolgt das Tempern bei einer Temperatur zwischen 300°C und 500 °C, um den Bereich 8 mit reduzierter elektrischer Leitfähigkeit unterhalb der ersten ZnO-Schicht 1 zu erzeugen.

Durch den Bereich 8 mit reduzierter elektrischer Leitfähigkeit wird der Stromfluss von einem elektrischen Anschlusskontakt 7 auf der ersten ZnO-Schicht 1 zu einem zweiten Anschlusskontakt 9, der beispielsweise auf der von der aktiven Zone 4 abgewandten Rückseite des Substrats 2 angeordnet ist, vorteilhaft in die Bereiche der aktiven Zone 4 geleitet, die dem Anschlusskontakt 7 nicht gegenüber liegen. Der bevorzugte Strompfad von dem Anschlusskontakt 7 zur aktiven Zone 4 innerhalb der Halbleiterschicht 3 wird in der Figur 1 b durch die Pfeile 10 angedeutet. Dieser Verlauf des Strompfads 10 hat den Vorteil, dass in den dem Anschlusskontakt 7 gegenüberliegenden Bereichen der aktiven Zone 4 nur ein verhältnismäßig geringer Anteil der von dem optoelektronischen Bauelement emittierten Strahlung erzeugt wird, wodurch die Absorptionsverluste in dem Anschlusskontakt 7 verringert werden.

Die erste ZnO-Schicht 1 und die zweite ZnO-Schicht 6 grenzen in diesem Ausführungsbeispiel aneinander an und bilden gemeinsam eine Stromaufweitungsschicht aus. Vorteilhaft sind die ZnO-Schichten 1, 6 mit bis zu drei Prozent A1 dotiert. Aufgrund der guten Querleitfähigkeit der ZnO-Schichten 1, 6, die auch bei dem Verfahrenschritt des Temperns erhalten bleibt, kann der Strom von dem Anschlusskontakt 7 durch die erste ZnO-Schicht 1 und die zweite ZnO-Schicht 6 in die Bereiche mit nicht oder nur geringfügig reduzierter elektrischer Leitfähigkeit der III-V-Halbleiterschicht 3 injiziert werden.

Das in den Figuren 2a, 2b und 2c dargestellte zweite Ausführungsbeispiel eines optoelektronischen Bauelements gemäß der Erfindung unterscheidet sich von dem in Figur 1 dargestellten im wesentlichen dadurch, dass die Stromeinprägung in die Halbleiterschicht 3 nicht über eine zweite ZnO-Schicht 6, sondern durch eine in strukturierter Form auf die Halbleiterschicht 3 aufgebrachte Kontaktschicht 11 erfolgt. Die Kontaktschicht 11 ist bevorzugt eine Metallschicht, die zur Ausbildung eines ohmschen Kontakts auf der Halbleiterschicht 3 geeignet ist, und kann insbesondere Au, Zn oder eine Verbindung dieser Materialien enthalten. Wie in der in Figur 2a zu erkennen ist, ist die Kontaktschicht 11 derart strukturiert, das sie in der Aufsicht den Umriss eines Quadrats beschreibt. Alternativ kann die Kontaktschicht 11 auch eine andere Strukturierung aufweisen. Die Kontaktschicht 11 ist über Verbindungsstege 12 mit dem zentral angeordneten Anschlusskontakt 7 verbunden. Wie in den in Fig. 2b und 2c dargestellten Querschnitten erkennbar ist, ist wie bei dem ersten Ausführungsbeispiel ist der Anschlusskontakt 7 auf der ersten ZnO-Schicht 1 angeordnet, die nach dem zuvor beschriebenen Verfahren zur Reduzierung der Leitfähigkeit der darunter liegenden Bereiche auf die III-V-Halbleiterschicht 3 aufgebracht und getempert wurde. Die Leitfähigkeit der Halbleiterschicht 3 ist daher auch bei diesem Ausführungsbeispiel in einem Bereich 8, der dem Anschlusskontakt 7 gegenüberliegt, reduziert, so dass die Stromeinprägung durch die Kontaktschicht 11 bevorzugt in diejenigen Bereiche der aktiven Zone 4 erfolgt, die dem Anschlusskontakt 7 nicht gegenüberliegen. Die Absorption der von dem optoelektronischen Bauelement emittierten Strahlung in dem Anschlusskontakt 7 wird dadurch vermindert und somit die Effizienz des Bauelements erhöht.

## Patentansprüche

1. Verfahren zur Herstellung von mindestens einem Bereich (8) mit reduzierter elektrischer Leitfähigkeit innerhalb einer elektrisch leitfähigen III-V-Halbleiterschicht (3), bei dem auf den Bereich (8) der Halbleiterschicht (3) eine ZnO-Schicht (1) aufgebracht und anschließend bei einer Temperatur von 300 °C bis 500 °C getempert wird, wodurch die elektrische Leitfähigkeit des Bereichs (8) mit reduzierter Leitfähigkeit gegenüber dem Bereich oder den Bereichen der III-V-Halbleiterschicht (3), die an den Bereich (8) mit reduzierter Leitfähigkeit angrenzen, um mindestens einen Faktor 2 reduziert wird.

2. Verfahren nach Anspruch 1,
bei dem die ZnO-Schicht (1) bei einer Temperatur von weniger als 150 °C auf die III-V-Halbleiterschicht (3) abgeschieden wird.

3. Verfahren nach Anspruch 1 oder 2,
bei dem das Abscheiden der ZnO-Schicht (1) mittels Sputtern erfolgt.

4. Verfahren nach einem der vorhergehenden Ansprüche,
bei dem die ZnO-Schicht vor dem Tempern strukturiert wird.

5. Verfahren nach einem der vorhergehenden Ansprüche,
bei dem die ZnO-Schicht (1) mit Al dotiert ist.

6. Verfahren nach einem der vorhergehenden Ansprüche,
bei dem die III-V-Halbleiterschicht (3) In_{1-x-y}GaₓAl_{y}P mit 0≤x+y≤1, 0≤x≤1, 0≤y≤1 oder Al₁₋ₓGaₓAs mit 0≤x≤1 umfasst.

7. Verfahren nach einem der vorhergehenden Ansprüche,
bei dem die III-V-Halbleiterschicht (3) p-dotiert ist.

8. Verfahren nach einem der vorhergehenden Ansprüche,
bei dem die elektrische Leitfähigkeit des Bereichs (8) der III-V-Halbleiterschicht (3) um mindestens einen Faktor 5 reduziert wird.

9. Verfahren nach einem der vorhergehenden Ansprüche,
bei dem die III-V-Halbleiterschicht (3) in einem optoelektronischen Bauelement enthalten ist.

10. Verfahren nach Anspruch 9,
bei dem das optoelektronische Bauelement eine strahlungsemittierende aktive Zone (4) enthält und mittels des Bereichs (8) mit reduzierter elektrischer Leitfähigkeit der Stromfluss (10) durch Teilbereiche der aktiven Zone (4) vermindert wird.

11. Verfahren nach Anspruch 10,
bei dem der Bereich (8) mit reduzierter elektrischer Leitfähigkeit zwischen einem elektrischen Anschlusskontakt (7) des optoelektronischen Bauelements und der aktiven Zone (4) angeordnet ist.

12. Verfahren nach einem der vorhergehenden Ansprüche,
bei dem die ZnO-Schicht (1) nach dem Tempern entfernt wird.

13. Verfahren nach einem der vorhergehenden Ansprüche,
bei dem eine erste ZnO-Schicht (1) auf einen ersten Bereich der Halbleiterschicht (3) abgeschieden wird, und eine zweite ZnO-Schicht (6) auf einen zweiten Bereich der Halbleiterschicht (3) abgeschieden wird, wobei die Abscheidtemperatur der zweiten ZnO-Schicht (6) gegenüber der Abscheidtemperatur der ersten ZnO-Schicht (1) derart erhöht ist, dass bei dem Tempern die Leitfähigkeit des zweiten Bereichs der Halbleiterschicht (3) zumindest weniger reduziert wird als die Leitfähigkeit des ersten Bereichs der Halbleiterschicht (3).

14. Verfahren nach Anspruch 13,
bei dem die zweite ZnO-Schicht (6) bei einer Temperatur von mehr als 150 °C abgeschieden wird.

15. Optoelektronisches Halbleiterbauelement mit einer III-V-Halbleiterschicht (3), die in mindestens einem ersten Bereich (8) mit einer ZnO-Schicht (1) bedeckt ist,
**dadurch gekennzeichnet, dass**
die Leitfähigkeit der Halbleiterschicht (3) in dem von der ZnO-Schicht (1) bedeckten ersten Bereich (8) um mindestens einen Faktor 2 geringer ist als in den lateral angrenzenden Bereichen der III-V-Halbleiterschicht (3).

16. Optoelektronisches Halbleiterbauelement nach Anspruch 15, bei dem die elektrische Leitfähigkeit des ersten Bereichs (8) der III-V-Halbleiterschicht (3) um mindestens einen Faktor 5 geringer ist als in den lateral angrenzenden Bereichen der III-V-Halbleiterschicht (3).

17. Optoelektronisches Halbleiterbauelement nach Anspruch 15 oder 16,
bei dem die ZnO-Schicht (1) mit Al dotiert ist.

18. Optoelektronisches Halbleiterbauelement nach einem der Ansprüche 15 bis 17,
bei dem die III-V-Halbleiterschicht (3) In_{1-x-y}GaₓAl_{y}P mit 0≤x+y≤1, 0≤x≤1, 0≤y≤1 oder Al₁₋ₓGaₓAs mit 0≤x≤1 umfasst.

19. Optoelektronisches Halbleiterbauelement nach einem der Ansprüche 15 bis 18,
bei dem eine zweite ZnO-Schicht (6) auf einen zweiten Bereich der Halbleiterschicht (3) abgeschieden ist und die Leitfähigkeit des zweiten Bereichs der Halbleiterschicht (3) größer ist als die Leitfähigkeit des ersten Bereichs (8).

20. Optoelektronisches Halbleiterbauelement nach Anspruch 19, bei dem die erste ZnO-Schicht (1) und die zweite ZnO-Schicht (6) aneinander angrenzen und zwischen der III-V-Halbleiterschicht (3) und einem Anschlusskontakt (7) des optoelektronischen Bauelements angeordnet sind.

21. Optoelektronisches Halbleiterbauelement nach Anspruch 20, bei dem die erste ZnO-Schicht (1) und die zweite ZnO-Schicht (6) gemeinsam eine Stromaufweitungsschicht ausbilden.

22. Optoelektronisches Halbleiterbauelement nach einem der Ansprüche 15 bis 21,
das eine strahlungsemittierende aktive Zone (4) enthält und der Bereich mit reduzierter elektrischer Leitfähigkeit (8) zwischen einem elektrischen Anschlusskontakt (7) des optoelektronischen Bauelements und der aktiven Zone (4) angeordnet ist.

## Claims

1. Method for producing at least one region (8) having reduced electrical conductivity within an electrically conductive III-V semiconductor layer (3), wherein a ZnO layer (1) is applied to the region (8) of the semiconductor layer (3) and is subsequently subjected to heat treatment at a temperature of 300°C to 500°C, as a result of which the electrical conductivity of the region (8) having reduced conductivity is reduced by at least a factor of 2 relative to the region or regions of the III-V semiconductor layer (3) which adjoin the region (8) having reduced conductivity.

2. Method according to Claim 1,
wherein the ZnO layer (1) is deposited onto the III-V semiconductor layer (3) at a temperature of less than 150°C.

3. Method according to Claim 1 or 2,
wherein the ZnO layer (1) is deposited by means of sputtering.

4. Method according to any of the preceding claims,
wherein the ZnO layer is structured before the heat treatment.

5. Method according to any of the preceding claims,
wherein the ZnO layer (1) is doped with Al.

6. Method according to any of the preceding claims,
wherein the III-V semiconductor layer (3) comprises In_{1-x-y}GaₓAl_{y}P where 0≤x+y≤1, 0≤x≤1, 0≤y≤1 or Al₁-ₓGaₓAs where 0≤x≤1.

7. Method according to any of the preceding claims, wherein the III-V semiconductor layer (3) is p-doped.

8. Method according to any of the preceding claims, wherein the electrical conductivity of the region (8) of the III-V semiconductor layer (3) is reduced by at least a factor of 5.

9. Method according to any of the preceding claims, wherein the III-V semiconductor layer (3) is contained in an optoelectronic component.

10. Method according to Claim 9,
wherein the optoelectronic component contains a radiation-emitting active zone (4) and the current flow (10) through partial regions of the active zone (4) is reduced by means of the region (8) having reduced electrical conductivity.

11. Method according to Claim 10,
wherein the region (8) having reduced electrical conductivity is arranged between an electrical connection contact (7) of the optoelectronic component and the active zone (4).

12. Method according to any of the preceding claims, wherein the ZnO layer (1) is removed after the heat treatment.

13. Method according to any of the preceding claims, wherein a first ZnO layer (1) is deposited onto a first region of the semiconductor layer (3), and a second ZnO layer (6) is deposited onto a second region of the semiconductor layer (3), wherein the deposition temperature of the second ZnO layer (6) is increased relative to the deposition temperature of the first ZnO layer (1) in such a way that, during the heat treatment, the conductivity of the second region of the semiconductor layer (3) is reduced at least to a lesser extent than the conductivity of the first region of the semiconductor layer (3).

14. Method according to Claim 13,
wherein the second ZnO layer (6) is deposited at a temperature of more than 150°C.

15. Optoelectronic semiconductor component comprising a III-V semiconductor layer (3), which is covered with a ZnO layer (1) in at least one first region (8), **characterized in that**
the conductivity of the semiconductor layer (3) in the first region (8) covered by the ZnO layer (1) is lower than in the laterally adjoining regions of the III-V semiconductor layer (3) by at least a factor of 2.

16. Optoelectronic semiconductor component according to Claim 15,
wherein the electrical conductivity of the first region (8) of the III-V semiconductor layer (3) is lower than in the laterally adjoining regions of the III-V semiconductor layer (3) by at least a factor of 5.

17. Optoelectronic semiconductor component according to Claim 15 or 16,
wherein the ZnO layer (1) is doped with Al.

18. Optoelectronic semiconductor component according to any of Claims 15 to 17,
wherein the III-V semiconductor layer (3) comprises In_{1-x-y}GaₓAl_{y}P where 0≤x+y≤1, 0≤x≤1, 0≤y≤1 or Al₁-ₓGaₓAs where 0≤x≤1.

19. Optoelectronic semiconductor component according to any of Claims 15 to 18,
wherein a second ZnO layer (6) is deposited onto a second region of the semiconductor layer (3) and the conductivity of the second region of the semiconductor layer (3) is greater than the conductivity of the first region (8).

20. Optoelectronic semiconductor component according to Claim 19,
wherein the first ZnO layer (1) and the second ZnO layer (6) adjoin one another and are arranged between the III-V semiconductor layer (3) and a connection contact (7) of the optoelectronic component.

21. Optoelectronic semiconductor component according to Claim 20,
wherein the first ZnO layer (1) and the second ZnO layer (6) jointly form a current spreading layer.

22. Optoelectronic semiconductor component according to any of Claims 15 to 21,
which contains a radiation-emitting active zone (4) and the region having reduced electrical conductivity (8) is arranged between an electrical connection contact (7) of the optoelectronic component and the active zone (4).

## Revendications

1. Procédé de fabrication d'au moins une zone (8) ayant une conductivité électrique réduite à l'intérieur d'une couche en semiconducteur III-V (3) électriquement conductrice, selon lequel une couche en ZnO (1) est appliquée sur la zone (8) de la couche en semiconducteur (3) et ensuite recuite à une température de 300 °C à 500 °C, ce par quoi la conductivité électrique de la zone (8) ayant une conductivité réduite est réduite d'au moins un facteur 2 par rapport à la zone ou aux zones de la couche en semiconducteur III-V (3) qui sont adjacentes de la zone (8) ayant une conductivité réduite.

2. Procédé selon la revendication 1, selon lequel la couche en ZnO (1) est déposée sur la couche en semiconducteur III-V (3) à une température inférieure à 150 °C.

3. Procédé selon la revendication 1 ou 2, selon lequel le dépôt de la couche en ZnO (1) s'effectue par pulvérisation cathodique.

4. Procédé selon l'une des revendications précédentes, selon lequel la couche en ZnO est structurée avant le recuit.

5. Procédé selon l'une des revendications précédentes, selon lequel la couche en ZnO (1) est dopée avec de l'Al.

6. Procédé selon l'une des revendications précédentes, selon lequel la couche en semiconducteur III-V (3) comprend de l'In_{1-x-y}GaₓAl_{y}P, avec 0 ≤ x+y ≤ 1, 0 ≤ x ≤ 1, 0 ≤ y ≤ 1 ou de l'Al₁₋ₓGaₓAs, avec 0 ≤ x ≤ 1.

7. Procédé selon l'une des revendications précédentes, selon lequel la couche en semiconducteur III-V (3) est dopée P.

8. Procédé selon l'une des revendications précédentes, selon lequel la conductivité électrique de la zone (8) de la couche en semiconducteur III-V (3) est réduite d'au moins un facteur 5.

9. Procédé selon l'une des revendications précédentes, selon lequel la couche en semiconducteur III-V (3) est contenue dans un composant optoélectronique.

10. Procédé selon la revendication 9, selon lequel le composant optoélectronique contient une zone active (4) émettrice de rayonnement et le flux de courant (10) à travers les zones partielles de la zone active (4) est réduit au moyen de la zone (8) ayant une conductivité électrique réduite.

11. Procédé selon la revendication 10, selon lequel la zone (8) ayant une conductivité électrique réduite est disposée entre un contact de raccordement électrique (7) du composant optoélectronique et de la zone active (4).

12. Procédé selon l'une des revendications précédentes, selon lequel la couche en ZnO (1) est retirée après le recuit.

13. Procédé selon l'une des revendications précédentes, selon lequel une première couche en ZnO (1) est déposée sur une première zone de la couche en semiconducteur (3) et une deuxième couche en ZnO (6) est déposée sur une deuxième zone de la couche en semiconducteur (3), la température de dépôt de la deuxième couche en ZnO (6) étant augmentée par rapport à la température de dépôt de la première couche en ZnO (1) de telle sorte que lors du recuit, la conductivité de la deuxième zone de la couche en semiconducteur (3) est réduite au moins dans une plus faible mesure que la conductivité de la première zone de la couche en semiconducteur (3).

14. Procédé selon la revendication 13, selon lequel la deuxième couche en ZnO (6) est déposée à une température supérieure à 150 °C.

15. Composant semiconducteur optoélectronique comprenant une couche en semiconducteur III-V (3) qui est recouverte d'une couche en ZnO (1) au moins dans une première zone (8),
**caractérisé en ce que**
la conductivité de la couche en semiconducteur (3) dans la première zone (8) recouverte par la couche en ZnO (1) est inférieure d'au moins un facteur 2 à celle dans les zones adjacentes latérales de la couche en semiconducteur III-V (3).

16. Composant semiconducteur optoélectronique selon la revendication 15, avec lequel la conductivité électrique de la première zone (8) de la couche en semiconducteur III-V (3) est inférieure d'au moins un facteur 5 à celle dans les zones adjacentes latérales de la couche en semiconducteur III-V (3).

17. Composant semiconducteur optoélectronique selon la revendication 15 ou 16, avec lequel la couche en ZnO (1) est dopée avec de l'Al.

18. Composant semiconducteur optoélectronique selon l'une des revendications 15 à 17, avec lequel la couche en semiconducteur III-V (3) comprend de l'In_{1-x-y}GaₓAl_{y}P, avec 0 ≤ x+y ≤ 1, 0 ≤ x ≤ 1, 0 ≤ y ≤ 1 ou de l'Al₁₋ₓGaₓAs, avec 0 ≤ x ≤ 1.

19. Composant semiconducteur optoélectronique selon l'une des revendications 15 à 18, avec lequel une deuxième couche en ZnO (6) est déposée sur une deuxième zone de la couche en semiconducteur (3) et la conductivité de la deuxième zone de la couche en semiconducteur (3) est supérieure à la conductivité de la première zone (8).

20. Composant semiconducteur optoélectronique selon la revendication 19, avec lequel la première couche en ZnO (1) et la deuxième couche en ZnO (6) sont adjacentes l'une à l'autre et sont disposées entre la couche en semiconducteur III-V (3) et un contact de raccordement (7) du composant optoélectronique.

21. Composant semiconducteur optoélectronique selon la revendication 20, avec lequel la première couche en ZnO (1) et la deuxième couche en ZnO (6) forment ensemble une couche d'élargissement du courant.

22. Composant semiconducteur optoélectronique selon l'une des revendications 15 à 21, lequel contient une zone active (4) émettrice de rayonnement et la zone (8) ayant une conductivité électrique réduite est disposée entre un contact de raccordement (7) électrique du composant optoélectronique et la zone active (4).
